# EUROPEAN PATENT APPLICATION

(11) **EP 4 524 298 A1**
(43) Date of publication of application: **19.03.2025**
(21) Application number: 24199423.5
(22) Date of filing: 10.09.2024
(51) Int. Cl.: C30B 35/00, C30B 25/00, C30B 29/36

(54) **REACTOR FOR EPITAXIAL DEPOSITION OF SEMICONDUCTOR MATERIAL ON SUBSTRATES WITH SLIDING SLEDGE FOR REACTION CHAMBER**

(30) Priority: 13.09.2023 IT 202300018780
(71) Applicant: LPE S.p.A., 20021 Baranzate (MI) (IT)
(72) Inventor: Meschia, Maurilio Giuseppe, Asti (IT); Crippa, Danilo, Novara (IT); Preti, Silvio Roberto Mario, Baranzate (MI) (IT); Corea, Francesco, Bollate (MI) (IT); Polli, Stefano, Baranzate (MI) (IT)
(74) Representative: De Gregori, Antonella

(57) **Abstract**

The innovative reactor is used for epitaxial deposition of semiconductor material on substrates and comprises a reaction chamber (210) extending along a longitudinal direction (L), a sledge (220) adapted to support the reaction chamber (210) or a portion of the reaction chamber, and a tube (230) extending along the longitudinal direction (L) and adapted to house the reaction chamber (210) and the sledge (220) supporting the reaction chamber (210); the sledge (220) is adapted to slide along the longitudinal direction (L) so as to extract/insert the reaction chamber (210) from/into the tube (230) when the reactor is in a non-operational condition.

## Description

### TECHNICAL FIELD

Reactors for epitaxial deposition of semiconductor material on substrates, or simply "epitaxial reactors" are here described.

In particular, the semiconductor material to be deposited is silicon carbide.

The substrates on which the deposition is performed are also typically made of silicon carbide, but other materials cannot be excluded.

### BACKGROUND ART

Reactors for epitaxial deposition of silicon carbide have been known for some time.

For example, in 2002, the Applicant filed two international patent applications related to such reactors and that were published as WO 2004/053187 A1 and WO 2004/053188 A1. The Applicant then filed first an international patent application related to a possible reaction chamber for such reactors and that was published as WO 2015/092525 A1 and then an international patent application related to a possible process for such reactors and that was published as WO 2022/053963 A1.

The reactors according to WO 2004/053187 A1 and WO 2004/053188 A1 have an architecture including a reaction chamber extending along a longitudinal direction, a thermal insulation also extending along the same longitudinal direction and a tube made of quartz (or similar material) also extending along the same longitudinal direction; the insulation laterally surrounds the chamber and the tube laterally surrounds the insulation. The cross-section of chamber, insulation and tube is substantially circular, elliptic or polygonal or rectangular in shape; typically, but not necessarily, the section of these three elements is in the same shape. The chamber and the insulation typically consist of several parts joined together, e.g., secured to one another.

One important aspect for any operating machine is its maintenance over time so that it is fully operational and always with excellent performance, as well as the possibility of carrying out the maintenance in a relatively simple and thus relatively cost-effective.

Typically, maintenance is of the periodic and/or predictive type.

Such an aspect is also very important for epitaxial reactors.

In this case, maintenance is particularly important for the reaction chamber and other components of the reactor which are subject to becoming dirty, in particular due to the spurious depositions of the semiconductor material, and/or which are subject to wear, in particular degradation of the surfaces thereof as a result of the repeated deposition processes.

### SUMMARY

Therefore, it is desirable to facilitate the maintenance in general of reactors for epitaxial deposition of semiconductor material on substrates, and in particular of reactors having an architecture identical or similar to that disclosed above.

Embodiments of reactors particularly suited for maintenance comprise at least one reaction chamber extending along a longitudinal direction, a sledge adapted to support the reaction chamber or a portion of the reaction chamber, and a tube extending along the longitudinal direction and adapted to house the reaction chamber and the sledge supporting the reaction chamber; the sledge is adapted to slide along the longitudinal direction so as to extract/insert the reaction chamber from/into the tube when the reactor is in a non-operational condition. A reactor is in a non-operational condition when a deposition process is not in progress therein and when the reaction chamber is at a low temperature, i.e., at a temperature much lower than the process temperature, e.g., at room temperature (less than 30°C) or at a temperature of just over room temperature (less than 50°C).

### BRIEF DESCRIPTION OF THE DRAWINGS

Reactors particularly suited for maintenance will become more apparent from the following detailed description to be considered in conjunction with the accompanying drawings, in which:
Fig. 1 shows a simplified, diagrammatic view of an embodiment of a reactor for epitaxial deposition of semiconductor material on substrates,
Fig. 2 shows a simplified, diagrammatic view of a first embodiment of a chamber assembly,
Fig. 3 shows three different views of the chamber assembly in Fig. 2 in three different positions,
Fig. 4 shows a simplified, diagrammatic view of a second embodiment of a chamber assembly, and
Fig. 5 shows three different views of the chamber assembly in Fig. 4 in three different positions.

As can easily be understood, there are various ways of practically making reactors particularly suited for maintenance and these are defined in the main advantageous aspects thereof in the appended claims and are neither limited by the following detailed description nor by the accompanying drawings.

It is specified that the technical features set out below relating to specific embodiments shall not be considered closely related to one another and shall thus not be considered mutually binding.

### DETAILED DESCRIPTION

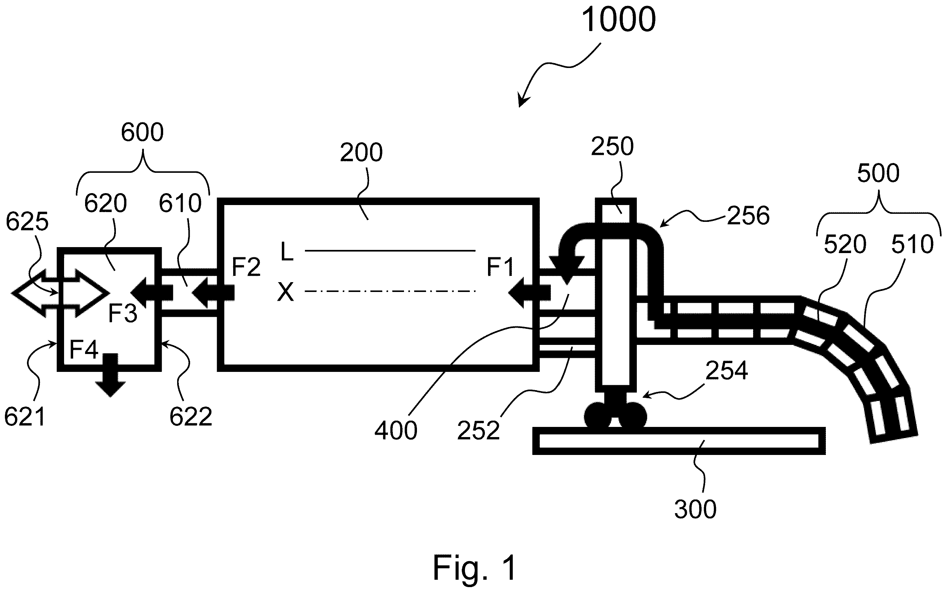

Fig. 1 shows, by way of non-limiting example, the architecture of an embodiment of a reactor 1000 for epitaxial deposition of semiconductor material, in particular and advantageously silicon carbide, on substrates, in particular and advantageously of silicon carbide.

The reactor 1000 comprises a chamber assembly 200, a set of components upstream of the assembly 200 (see for example reference numerals 300, 400 and 500 in the figure), and a set of components downstream of the assembly 200 (see for example reference numeral 600 in the figure); the terms "upstream" and "downstream" refer to the position with respect to the chamber assembly 200 considering the gas flow in the reactor. The assembly upstream and the assembly downstream will be described below.

The chamber assembly 200 is the part of the reactor 1000 where the epitaxial deposition on substrates takes place; in particular, there is a "reaction and deposition zone" inside the chamber 200. Process gases enter the assembly 200 from the assembly upstream (see arrow F1); in particular, the process gases enter the "reaction and deposition zone". Exhaust gases exit the assembly 200 towards the assembly downstream (see arrow F2); in particular, the exhaust gases exit the "reaction and deposition zone". In general, as known, both the process gases and the exhaust gases contain carrier gases, e.g., hydrogen or helium or argon, or a mixture of two or more of these substances.

Fig. 1 shows no detail of the assembly 200; only an axis X thereof and a longitudinal extension direction L thereof are highlighted. The axis X can be an axis of substantial symmetry of the assembly 200. The direction L is not only the longitudinal extension direction extension, but also the direction according to which the gas flow substantially takes place through the assembly.

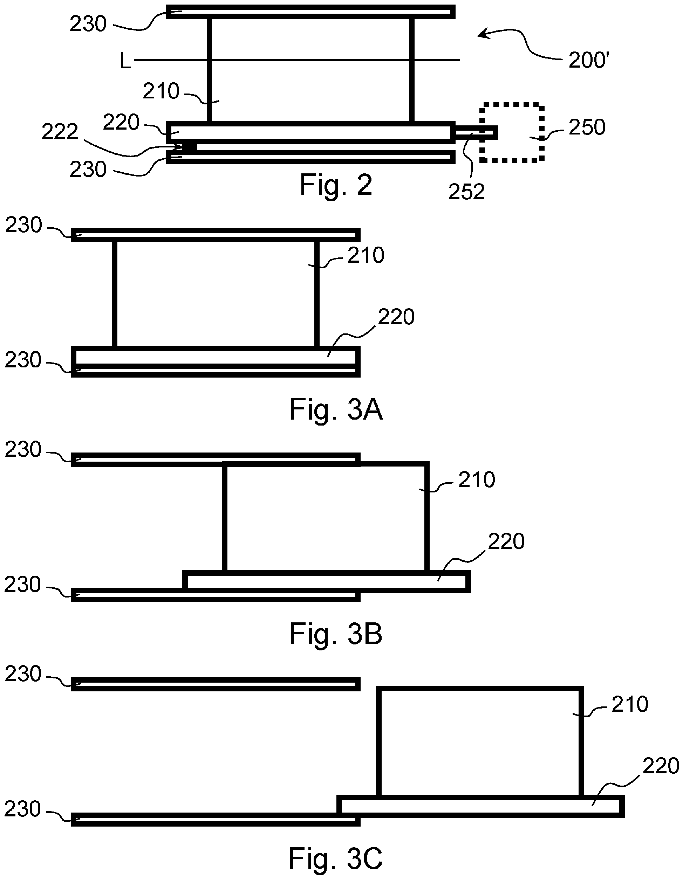

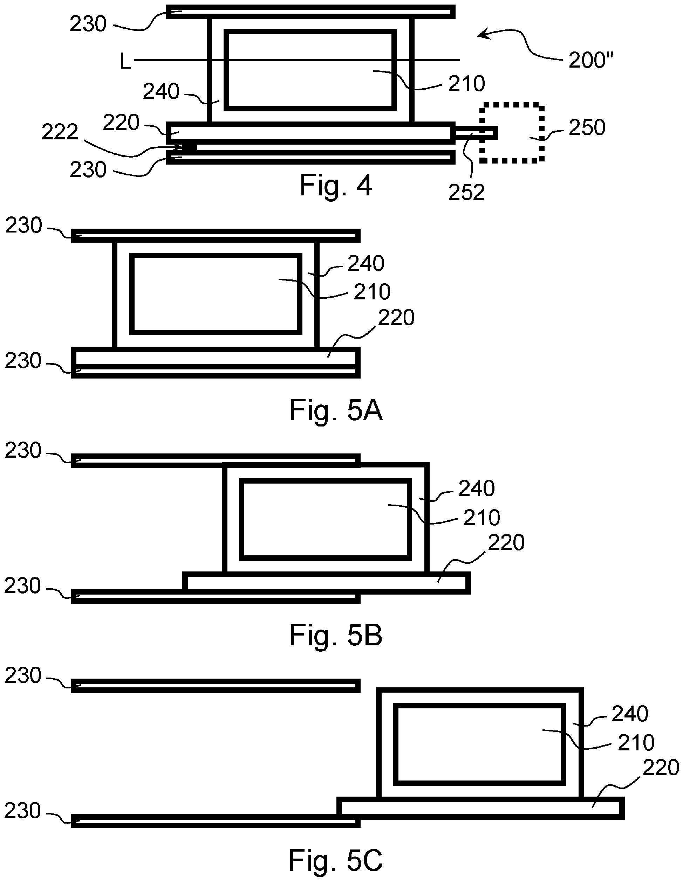

Two embodiments of the assembly 200 (slightly different) are shown in Figs. 2 and 4, respectively, and are indicated by reference numerals 200' and 200", respectively.

It should be noted that the architecture of the reactor 1000 is also suitable for chamber assemblies, which differ from the assembly 200' in Fig. 2 and the assembly 200" in Fig. 4.

It should also be noted that the embodiments of the assembly 200 shown in Figs. 2 and 4 can be inserted into reactors other than that shown in Fig. 1.

The reactor 1000 comprises a reaction chamber, a sledge, a tube, and typically a thermal insulation as well; these three or four components are part of the chamber assembly 200.

Specifically, with reference to Fig. 2 and Fig. 4, the assembly 200'/200" comprises:
- a reaction chamber 210 extending along the longitudinal direction L,
- a sledge 220 adapted to support (directly as shown in Fig. 2 or indirectly as shown in Fig. 4) the reaction chamber 210, and
- a tube 230 extending along the longitudinal direction L and adapted to house at least the reaction chamber 210 and the sledge 220.

The sledge 220 is adapted to slide along the longitudinal direction L so as to extract/insert at least the reaction chamber 210 from/into the tube 230 when the reactor is in the non-operational condition, in particular for operations of maintenance.

Fig. 4 shows a thermal insulation 240 extending along the longitudinal direction L and arranged around the reaction chamber 210, so as to enclose and thermally insulate it. The insulation 240 is enveloping, i.e., it completely encloses the chamber 210, i.e., both radially and axially.

It should be noted that Fig. 2 does not show a thermal insulation. A thermal insulation can be absent if the maximum temperature reached by the reaction chamber during the processes is low, i.e., it can be tolerated by the sledge supporting the reaction chamber. Alternatively, a thermal insulation can be small, i.e., located only between the reaction chamber and the sledge supporting the reaction chamber.

The embodiment in Fig. 4 differs from the embodiment in Fig. 2 essentially in that the sledge 210 is also adapted to support the enveloping thermal insulation 240. Therefore, when the sledge slides, not only the whole reaction chamber 210, but also the whole enveloping thermal insulation 240 is to be extracted/inserted from/into the tube 230.

Fig. 3A shows the assembly 200' (in Fig. 2) in a first condition in which the chamber 210 is completely inside the tube 230. The sledge 220 is also completely inside the tube 230.

Fig. 3B shows the assembly 200' (in Fig. 2) in a second condition in which the chamber 210 is partially inside and partially outside the tube 230. The sledge 220 is also partially inside and partially outside the tube 230.

Fig. 3C shows the assembly 200" (in Fig. 2) in a third condition in which the chamber 210 is completely outside the tube 230. The sledge 220 is almost completely outside the tube 230.

Fig. 5A shows the assembly 200" (in Fig. 4) in a first condition in which the chamber 210 and the insulation 240 are completely inside the tube 230. The sledge 220 is also completely inside the tube 230.

Fig. 5B shows the assembly 200" (in Fig. 4) in a second condition in which the chamber 210 and the insulation 240 are partially inside and partially outside the tube 230. The sledge 220 is also partially inside and partially outside the tube 230.

Fig. 5C shows the assembly 200' (in Fig. 4) in a third condition in which the chamber 210 and the insulation 240 are completely outside the tube 230. The sledge 220 is almost completely outside the tube 230.

When the chamber 210 and possibly the insulation 240 are outside, in particular completely outside the tube 230, they can undergo inspections and maintenance. For example, they can be first opened and then closed again. For example, one or more parts can be replaced or cleaned or repaired.

The sledge can be adapted to support the whole chamber or only a portion of the chamber. In this second case, the sledge can be adapted to extract/insert such a portion of the chamber from/into the tube.

The sledge can be adapted to support the whole insulation or only a portion of the insulation. In this second case, the sledge can be adapted to extract/insert such a portion of the insulation from/into the tube.

The section of the reaction chamber can have a substantially circular or elliptic or polygonal or rectangular outer shape.

The section of the thermal insulation can have a substantially circular or elliptic or polygonal or rectangular outer and/or outer shape.

The section of the tube can have a substantially circular or elliptic or polygonal or rectangular inner and/or outer shape.

The above shapes can be the same or different. Typically, the outer shape of the reaction chamber corresponds to the inner shape of the thermal insulation. Typically, the outer shape of the thermal insulation corresponds to the inner shape of the tube.

Advantageously, the sledge is cradle-shaped, i.e., it comprises a portion adapted to receive part of the reaction chamber and/or part of the thermal insulation. Such a portion can comprise a lower wall and, advantageously, a front wall (e.g., a flat sheet) at a first longitudinal end zone of the lower wall, and/or a rear wall (e.g., a flat sheet) at a second longitudinal end zone of the lower wall. The cross-section of the lower wall can be in the shape of an arc of a circle or an arc of an ellipse or a broken line.

The reaction chamber is typically made of (compact) graphite so as to be heated by electrical induction. It typically consists of several parts joined together, e.g., secured to one another.

The thermal insulation is typically made of (porous or fibrous) graphite. It typically consists of several parts joined together, e.g., secured to one another.

It can generally be said that the tube is typically made of quartz.

According to some embodiments (the most typical ones), the tube only consists of a single tubular element made of quartz.

According to other embodiments, the tube can consist of two tubular elements together, one (external) made of quartz and one (internal) made of (porous or fibrous) graphite. The two tubular elements can be constrained to each other.

In order for the sledge to slide back and forth, there are basically three possible cases: A) the sledge completely rests (in particular at both a first end zone thereof and at a second end zone thereof), B) the sledge is completely suspended (in particular at both a first end zone thereof and at a second end zone thereof), C) the sledge rests at a first end zone thereof (in particular the rear zone) and is suspended at a second end zone thereof (in particular the rear zone). The terms "rear" and "front" refer to the gas flow in the reactor; when flowing, the gas meets first the "front" of the chamber and then the "rear" of the chamber.

Typically, the cradle rests on the inner wall of the tube.

The examples in Figs. 2 and 4 correspond to the case C, in particular to the case in which the sledge rests at the rear zone thereof (which is on the left in all figures from Fig. 1 to Fig. 5) and is suspended at the front end zone (which is on the right in all figures from Fig. 1 to Fig. 5). In particular, the rear zone is close to the zone of the chamber where the gases exit and the front zone is close to the zone where the gases enter.

In the examples in Figs. 2 and 4, the sledge 220 comprises at least one pad 222 directly resting on an inner surface of the tube 230; advantageously, the pad 222 is adapted to slide on this inner surface, e.g., by means of quartz-on-quartz contact. Advantageously, the pad 222 is located at a first end zone of the sledge 220, in particular the rear end zone thereof. In Figs. 3C and 5C, the sledge 220 is almost completely outside the tube 230, but the pad 222 remains resting on the tube 230 and thus inside the tube 230.

In the examples in Figs. 2 and 4 (and as highlighted by these figures), the sledge 220 is suspended at a second end zone of the sledge 220, in particular the front zone thereof.

According to the examples in Figs. 2 and 4, the sledge also remains inside the tube during normal operation of the reactor, in particular during the epitaxial deposition processes. This solution is advantageous since it makes the reactor simpler from a structural point of view. Obviously, in this case, the sledge must be made of a material resistant to high temperatures, in particular to the process temperature.

It is explained below how to obtain the suspension of the sledge with everything resting thereon.

It is also explained below how to move the sledge with everything resting thereon.

The reactor 1000 of the embodiment in Fig. 1 also comprises a movement assembly 250 (also visible in Figs. 2 and 4, but not in Figs. 3 and 5) located substantially outside the tube 230. The sledge 220 is constrained to the assembly 250. Such a constraint can allow the assembly 250 to push and pull, and thus move, the sledge 210 supporting at least the reaction chamber 210. Such a constraint can allow the assembly 250 to keep the sledge 210 suspended. Such a constraint can allow both things; in particular, the assembly 250 comprises an arm 252 (also visible in Figs. 2 and 4, but not in Figs. 3 and 5) configured so as to constrain and support the sledge 220 at the front end zone thereof; alternatively, but less advantageously, the sledge could be provided with an arm adapted to be secured to the movement assembly.

According to the embodiment in Fig. 1, the assembly 250 comprises a plate, typically rather large in size and made of a metal material, which can be arranged transversely to the axis X of the chamber 210, is movable and is always outside the tube 230 in any condition of the reactor 1000; on the contrary, the arm 252 can be partially inside the tube 230 being constrained to the sledge 220. The plate can be considered as the body of the assembly 250.

As anticipated and diagrammatically shown in Fig. 1 by the arrows F 1 and F2, the process gases enter the chamber assembly 200 (on the right in Fig. 1), in particular the reaction chamber 210 (in particular, the "reaction and deposition zone" thereof), and the exhaust gases exit the assembly 200 (on the left in Fig. 1), in particular the reaction chamber 210 (in particular the "reaction and deposition zone" thereof). It cannot be excluded that other fluids, gases and/or liquids can enter and/or exit the chamber assembly 200 for other purposes, e.g., cooling.

Important, advantageous, but not strictly indispensable components of an epitaxial reactor upstream of the chamber assembly will now be described with the non-limiting aid of Fig. 1.

The reactor 1000 also comprises an outer track 300 outside (typically completely outside) the tube 230. The movement assembly 250 comprises a skid 254 adapted to slide along the track 300, typically back and forth. The skid 254 is typically secured to the body of the assembly 250, in particular is secured to the plate. The skid 254 is advantageously associated with a motor, in particular an electric motor; thereby, the movement of the assembly 250 is motorized and can be accurately controlled.

Since the body of the assembly is constrained to the sledge, when the body moves, it pushes or pulls the sledge depending on the movement direction and thus moves at least the reaction chamber.

Advantageously, the function of the assembly 250 is not only the movement of the reaction chamber. In particular, the assembly 250 can comprise connections 256 for the connection with at least ducts for process gases, in particular precursor gases and transport gases.

The reactor 1000 can also comprise a guide assembly 400 adapted to carry process gases to the reaction chamber 210. The guide assembly 400 can be fluidically coupled to the connections 256 of the assembly 250.

According to the example in Fig. 1, the assembly 400 is secured to the body of the assembly 250 and thus moves integrally therewith. Advantageously, a spring (or several springs) can be provided, which compresses when the assembly 400, moving towards the tube, reaches the end stop, and which decompresses when the assembly moves away from the tube.

In the example in Fig. 1, it is noted that the process gases flow into the assembly 400, advantageously transversely to the longitudinal direction L, and flow out of the assembly 400, advantageously parallel to the longitudinal direction L. In this manner, i.e., with said "L"-shaped configuration, the longitudinal size of the assembly 400 can be reduced.

In the example in Fig. 1, the connections 256 are roughly configured as an upside-down "U". Thereby, *inter alia,* the "L"-shaped configuration of the assembly 400 is simpler to place.

In the example in Fig. 1, advantageously, the reactor 1000 also comprises a flexible chain 510 containing at least flexible ducts 520 for process gases therein. The flexible ducts 520 are fluidically coupled to the connections 256 of the assembly 250.

The flexible chain 510 is adapted to bend relative to the sliding of the skid 254 and the fluidic coupling between ducts 520 and connections 256 is maintained irrespective of the position of the assembly 250.

The fluidic coupling between the reaction chamber 210 and the guide assembly 400 can consist of one or more pieces of various materials (not shown in Fig. 1). The assembly 400 can include a portion farther away from the reaction chamber 210, which can be referred to as the "liner", and a portion closer to the reaction chamber 210, which can be referred to as the "transition piece"; the farther portion is typically made of quartz; the closer portion can be made of bare graphite or coated graphite (e.g., coated with silicon carbide) or silicon carbide; the "transition piece" serves to avoid a "thermal break" between the chamber and the "liner" and avoid (or at least limit) spurious depositions on the "liner".

In the zone where the assembly 440 is located, one or more thermal shields are also advantageously located (not shown in Fig. 1.

Important, advantageous, but not strictly indispensable components of an epitaxial reactor downstream of the chamber assembly will now be described with the non-limiting aid of Fig. 1.

As shown in Fig. 1, all these components correspond to a discharge assembly 600; however, additional components with respect to those shown in Fig. 1. Furthermore, it should be clear that Fig. 1 is a diagrammatic drawing and therefore the relative dimensions in both the vertical direction and the horizontal direction are not significant.

Such an assembly has the main function of discharging the exhaust gases exiting the reaction chamber 210 of the chamber assembly 200, in particular from the "reaction and deposition zone". Advantageously, a second function of such an assembly is to allow loading into the reaction chamber 210 the substrates still waiting to undergo epitaxial deposition and unloading from the reaction chamber 210 the substrates already subjected to epitaxial deposition.

The discharge assembly 600 comprises an outlet drum 620 fluidically coupled to an outlet of the reaction chamber 210. For example, the drum 620 can have a cross-section which is substantially circular or elliptic or polygonal or rectangular in shape.

Advantageously, the outlet drum 620 is configured so that exhaust gases enter the drum in the axial or substantially axial direction (see the black arrow F3 in Fig. 1), and exit the drum in the radial or substantially radial direction (see the black arrow F4 in Fig. 1). In the embodiment in Fig. 1, the exit of the exhaust gases takes place from a first side of the outlet drum, in particular the lower side (see the black arrow F4 in Fig. 1); for example, if the cross-section of the drum is circular (i.e., the drum is cylindrical), "lower side means a portion, e.g., of 60°-90°, of the side surface facing downwards.

The longitudinal dimension of the reactor is thus reduced. Furthermore, the movement of the substrates (for loading and unloading) is thus facilitated. Finally, as explained better below, maintenance of the discharge zone of the reactor is thus facilitated. Therefore, there are three advantageous reasons for configuring the outlet drum as schematized in Fig. 1.

The fluidic coupling between the reaction chamber 210 and the outlet drum 620 can be obtained by virtue of a connection assembly 610 which guides the exhaust gases. It can be formed by one or more pieces of various materials. In the assembly 610, there could be, for example, a so-called "protection ring" (or more than one connected to the assembly), which has the purpose of thermally distancing and separating the chamber from the drum; for example, this allows avoiding (or at least limiting) thermal damage to any gaskets (such as "O-rings") of the drum; the "protection ring" could consist of a tubular element made of bare graphite or coated graphite (e.g., coated with silicon carbide) or of silicon carbide. In addition to such a "protection ring", there could also be a tubular element made of quartz, for example.

Advantageously, the outlet drum 620 is configured so that the substrates can cross it moving from a first side 621 to a second side 622 (see the right-facing white arrow in Fig. 1) to load the substrates into the reaction chamber, or from the second side 622 to the first side 621 (see the left-facing white arrow in Fig. 1) to unload the substrates from the reaction chamber. Fig. 1 diagrammatically shows a so-called "gate valve" 625 adapted to open for allowing the passage of the substrates and to close for sealing the outlet drum 620; the gate valve 625 is on the side 621 of the drum 620 opposite to the side 622 where the drum is in communication with the assembly 200, in particular the reaction chamber 210.

It should be noted that the substrates are typically carried on substrate holders. Therefore, both the outlet drum 620, in particular the gate valve 625 thereof and the connection assembly 610 are advantageously dimensioned so as to allow the passage of a substrate holder and a related handling device.

Advantageously, the outlet drum 620 has, on the side surface of the drum in a position opposite to the radial outlet of the gases, at least one hatch which allows accessing the interior of the drum and replacing internal parts of the reactor which lie in the discharge zone of the reactor. In the embodiment in Fig. 1, it can be located on a second side of the outlet drum, in particular the upper side; for example, if the cross-section of the drum is circular (i.e., the drum is cylindrical), "upper side" can mean a portion, e.g., of 60°-90°, of the side surface facing upwards.

It should be noted that the description given in relation to the components upstream of the chamber assembly and the description given in relation to the components downstream of the chamber assembly are not strictly mutually related, and are not even related to the description given in relation to the chamber assembly in Figs. 2 and 4.

## Claims

1. Reactor for epitaxial deposition of semiconductor material on substrates, wherein the reactor comprises:
a reaction chamber (210) that extends along a longitudinal direction (L),
a sledge (220) adapted to support the reaction chamber (210) or a portion of the reaction chamber, and
a tube (230) that extends along said longitudinal direction (L) and that is adapted to house the reaction chamber (210) and the sledge (220) supporting the reaction chamber (210);
wherein the sledge (220) is adapted to slide along said longitudinal direction (L) in such a way that the reaction chamber (210) can be extracted/inserted from/into said tube (230) when the reactor is in non-operational condition.

2. Reactor according to claim 1,
wherein the reactor comprises also a thermal insulation (240) that extends along said longitudinal direction (L) and is arranged around the reaction chamber (210), and
wherein said sledge (220) is adapted to support also the thermal insulation (240) or a portion of the thermal insulation.

3. Reactor according to claim 1 or 2,
wherein said sledge (220) comprises at least one pad (222) that rests on an inner surface of said tube (230) and, in particular, that is adapted to slide on said inner surface.

4. Reactor according to claim 3,
wherein said pad (222) is located at a first end zone of said sledge (220).

5. Reactor according to any of the preceding claims,
wherein the reactor comprises also a movement assembly (250) positioned outside said tube (230),
wherein said sledge (220) is constrained to said movement assembly (250), and
wherein said movement assembly (250) is adapted to pull and push the sledge (210) supporting at least the reaction chamber (210).

6. Reactor according to claim 5,
wherein said movement assembly (250) comprises an arm (252) configured to constrain and support said sledge (220) at a second end zone of said sledge (220).

7. Reactor according to claim 5 or 6,
wherein the reactor comprises also a track (300) outside said tube (230), wherein said movement assembly (250) comprises a skid (254), and wherein said skid (254) is adapted to slide along said track (300).

8. Reactor according to claim 5 or 6 or 7,
wherein said movement assembly (250) comprises connections (256) at least for process gas ducts.

9. Reactor according to claim 8,
wherein the reactor comprises also a guide assembly (400) to feed process gas to the reaction chamber (210), and
wherein said guide assembly (400) is fluidically coupled to the connections (256) of said
movement assembly (250).

10. Reactor according to claim 8 or 9,
wherein the reactor comprises also a flexible chain (510) containing internally at least flexible ducts (520) for process gas, and
wherein said flexible ducts (520) are fluidically coupled to the connections (256) of said movement assembly (250).

11. Reactor according to claim 7 and claim 10,
wherein said flexible chain (510) is adapted to bend in relation to the sliding of said skid (254).

12. Reactor according to any of the preceding claims,
wherein the reactor comprises also a discharge assembly (600) for discharging exhaust gases,
wherein said discharge assembly (600) comprises an outlet drum (620) fluidically coupled to an outlet of the reaction chamber (210), and
wherein said discharge assembly (600) is configured so that substrates may cross said outlet drum (620) passing from a first side to a second side or from said second side to said first side.

13. Reactor according to claim 12,
wherein said outlet drum (620) is configured so that exhaust gases enter the outlet drum in the axial direction and exit the outlet drum in the axial direction.
